# EUROPEAN PATENT APPLICATION

(11) **EP 0 577 114 A2**
(43) Date of publication of application: **05.01.1994**
(21) Application number: 93110477.2
(22) Date of filing: 30.06.1993
(51) Int. Cl.: G01R 33/032

(54) **Reflection type magneto-optic sensor head**

(30) Priority: 01.07.1992 JP 174357/92; 30.11.1992 JP 320379/92
(71) Applicant: MITSUBISHI GAS CHEMICAL COMPANY, INC., Tokyo, 100 (JP)
(72) Inventor: Shirai, Kazushi, c/o Mitsubishi Gas Chem.Comp.Inc., Katsushika-ku, Tokyo 125 (JP); Takeda, Norio, c/o Mitsubishi Gas Chem.Comp.Inc., Katsushika-ku, Tokyo 125 (JP); Shimono, Yasuo, c/o Mitsubishi Gas Chem.Comp.Inc., Katsushika-ku, Tokyo 125 (JP); Arii, Mitsuzo, c/o Mitsubishi Gas Chem.Comp.Inc., Katsushika-ku, Tokyo 125 (JP); Shinbo, Toshihiro, Mitsubishi Gas Chem.Comp.Inc., Katsushika-ku, Tokyo 125 (JP)
(74) Representative: KUHNEN, WACKER & PARTNER

(57) **Abstract**

A reflection type magneto-optic sensor head having a light inputting/outputting path, polarizer, Faraday rotator, and reflecting film which are aligned in that order. The Faraday rotator is made of a plurality of (111) bismuth-substituted iron garnet single crystals (22-25), which are selected from (111) bismuth-substituted iron garnet single crystals having a [111] axis at an angle (γ) in the range of 1-60 degrees with an axis normal to the film surface and (111) bismuth-substituted iron garnet single crystals having a [111] axis substantially in line with an axis normal to the film surface.

## Description

### BACKGROUND OF THE INVENTION

### Field of the Invention

The present invention relates to a magnetooptic sensor head based on Faraday effect of a bismuth-substituted iron garnet film, and more particularly to a small, light, and easy-to-manufacture reflection type magnetooptic sensor for detecting changes in magnetic field.

### Prior Art

Today, many of conventional industrial apparatuses and consumer equipment include rotating devices or rotating mechanisms such as motors and gears. The advances in science and technology have enabled to accurately control rotating apparatuses for industrial use such as aircraft and ships as well as consumer apparatuses such as automotive vehicles. Accurate control of rotations enables efficient use of energy, allowing to address the problems such as conservation of global environment and energy saving.

For more accurate and sophisticated control of rotating apparatuses, the rotational speeds of the apparatuses must be measured continuously, accurately, and quickly. This measurement necessitates reliable and accurate measuring devices. Up until now, there has been no measuring device which is inexpensive, small, light, easy-to-use, available in large quantities, and suitable for continuous use over a long time under vibration and elevated temperatures.

There have been proposed a variety of methods for measuring rotational speeds. One such method makes use of electromagnetic induction (Sensor Gijutsu, page 68, December, 1986). Another uses a magnetooptic sensor based on Faraday effect of magnetooptic materials (Applied Optics, Vol.28, No.11, page 1992, 1989).

The method based on electromagnetic induction has been used in measuring the rotational speeds of engines for aircraft and automotive vehicles. This type of rotational speed meter is susceptible to electromagnetic noise that comes in through the cables connecting the probe and the main body of the tachometer. Furthermore, since electric circuits are involved, the meter must be designed so that the electric circuits will not cause explosion when used in the environment where flammable materials including organic solvents are used or stored.

A magnetooptic sensor head based on Faraday effect of a magnetooptic material, makes use of changes in rotation of polarization plane of the magnetooptic material in response to the presence and absence of a magnetic field (or magnet) when a permanent magnet (or magnetic field) approaches the magnetooptic material. That is, the polarization plane of a light is rotated while the light is transmitted through a magnetooptic material incorporated in a magnetooptic sensor head. The rotation of polarization plane is then converted into changes in light intensity, and the number of changes is counted to determine the rotational speed (National Technical Report, Vol.29, No.5, p70, (1983)).

Magnetooptic sensors include a transmission type and a reflection type. With the transmission type, because of the nature of the structural elements used, the elements must be aligned in a straight line so that the light travels straightly. Thus, if some obstructions are located in the course of the light, the magnetooptic sensor head cannot operate properly.

Japanese Patent Preliminary Publication No.56-55811 discloses the reflection type magnetooptic sensor head which overcomes the deficiencies of the transmission type magnetooptic sensor head. This magnetooptic sensor has an input light path through which a signal light enters the Faraday rotator, and an output light path which the signal light exiting the Faraday rotator enters. These two light paths are aligned to extend in substantially parallel to each other so that the light travels along the input path toward the Faraday rotator, is reflected back by a reflector behind the Faraday rotator, and returns along the output light path. In other words, the Faraday rotator is mounted at the tip end of the magnetooptic sensor and thus the magnetooptic sensor head is elongated and slim in shape, which is advantageous in that the sensor head can be installed in a narrow space where a transmission type magnetooptic sensor head cannot be installed.

However, the reflection type sensor head of Matsui et al. is disadvantageous in that one lens must be in series with the polarizer while the other lens must be in series with the analyzer, and these two series connections must be in parallel to each other. This requirement of aligning the series connections side by side places limitations on automatic assembly operation of the entire system in production, and is not cost effective.

Japanese Patent Publication No.3-22595 granted to Matsumura et al. discloses a configuration where the polarizer and the analyzer are replaced by a single polarizer. This configuration overcomes the deficiency of the reflection type magnetooptic sensor head proposed by Matsui et al.

Matsumura et al. employed yttrium iron garnet (Y₃Fe₅O₁₂), usually referred to as YIG, as a Faraday rotator produced by flux melt technique. The YIG is advantageous as a Faraday rotator element in that Faraday rotation coefficient (deg/cm) is larger in YIG than in paramagnetic glass and zinc selenide. The use of YIG proposed by Matsumura et al. is one way of overcoming the deficiency of a reflection type magnetooptic sensor head. In fact, the use of YIG is of great interest as a Faraday rotator element. However, YIG may not be a practical material as a Faraday rotator since it is well known that YIG transmits near infrared rays having wavelengths longer than 1.1 µm and absorbs lights in the 0.8 µm band.

Conventionally, an optical sensor head uses a light source such as semiconductor laser (LD) or light emitting diodes (LED). These light sources have median wavelengths in the range of 0.78-0.85 µm. Semiconductor laser and light emitting diodes are used as a light source for an optical sensor because they are very inexpensive in the above wavelength range as well as conventional photodetectors exhibit good sensitivity in the range. Using light sources available on the market is most preferred and is the best way to provide inexpensive magnetooptic sensor heads in order to meet the user's needs.

High light absorption of YIG in the 0.8 µm band implies that the use of a light source available on the market makes it difficult to detect light. That is, YIG is inherently deficient as a Faraday rotator.

The inventors of the present invention investigated many other materials in order to overcome the deficiency of YIG. The inventors concluded that bismuth-substituted iron garnets could be used as a magnetooptic material. The bismuth-substituted iron garnets can be manufactured rather easily by the LPE (Liquid Phase Epitaxial) method, and lends itself to mass production. Bismuth-substituted iron garnets are represented by a chemical formula (RBi)₃(FeA)₅O₁₂, where R represents yttrium Y or rare earth elements and A represents aluminum Al and gallium Ga.

The Faraday rotation coefficient of a bismuth-substituted iron garnet, i.e., the rotation angle of the polarization plane per unit film thickness at a saturated magnetization is several times greater than that of YIG, in fact about ten times as large at a wavelength of 0.8 µm as YIG. This indicates that the film thickness can be smaller with increasing Faraday rotation coefficient, achieving less light absorption loss and smaller size for the same amount of magnetooptic effect. Thus, bismuth-substituted iron garnets are useful in implementing a magnetooptic sensor head with a light source having a wavelength of 0.8 µm band.

The magnetic saturation of bismuth-substituted iron garnets ranges from 500 to 1200 Oe which are about half that of YIG (about 1800 Oe). This indicates that the bismuth-substituted iron garnets can be used to measure weak magnetic fields as well. The ability to measure weak magnetic fields implies that the absence and presence of the magnetic field can be detected even if the magnetooptic sensor head is located far away from a magnet. This offers more flexibility and higher degrees of freedom in installing the magnetooptic sensor head and suggests wider fields of application for magnetooptic sensor heads.

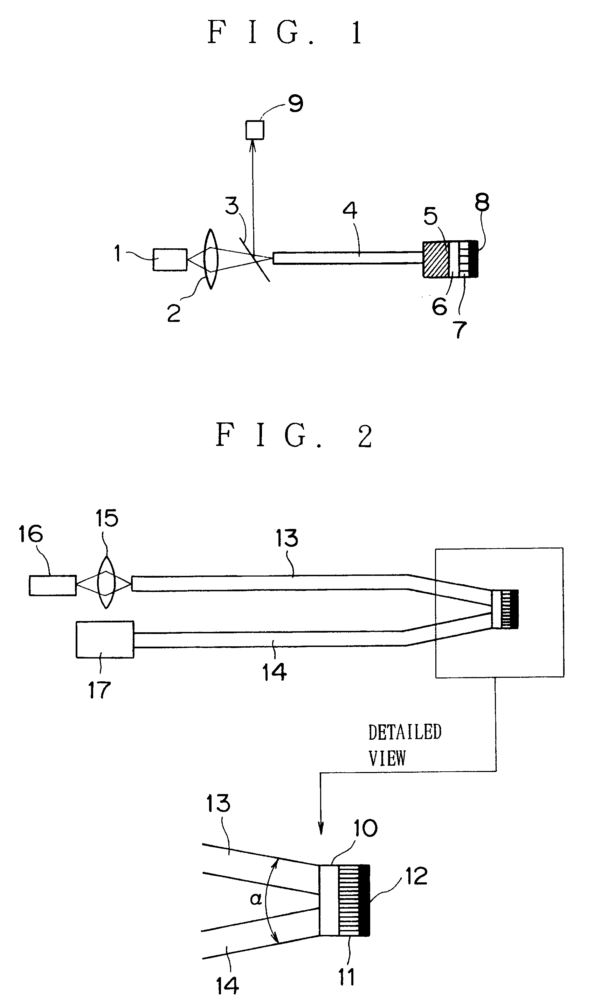

With the result of the aforementioned investigation, the inventors of the present invention believed that reflection type magnetooptic sensor heads can be developed by the use of bismuth-substituted iron garnets as a Faraday rotator. Based on the disclosure in Japanese Patent Publication No.3-22595, the inventors of the present invention built an engineering model of a reflection type magnetooptic sensor head as shown in Fig. 1 using a Faraday rotator made of a bismuth-substituted iron garnet single crystal in place of YIG.

In Fig. 1, a light source 1 takes the form of a semiconductor laser and emits a light, which passes through a lens 2, a half mirror 3, an optical fiber 4, to lens 5 which converts an incoming light into a parallel light. Then, the light enters a polarizer 6. The light exiting the polarizer 6 is a linearly polarized light and enters a Faraday rotator 7. The light is then reflected back by a reflecting film 8 in the form of a metal thin film and passes through the Faraday rotator 7, polarizer 6, lens 5, optical fiber 4 to mirror 3 which reflects the light to the photodetector 9. The lens 5 is, for example, a grated refractive index lens and the polarizer is, for example, a rutile single crystal. The Faraday rotator 7 is made of a bismuth-substituted iron garnet.

Then, using the thus built reflection type magnetooptic sensor head with a bismuth-substituted iron garnet as a Faraday rotator, the inventors made a variety of experiments for various magnetic field intensities. However, the sensor head failed to detect any light signal regardless of whether the sensor head is applied with a magnetic field or not.

Therefore, the inventors made further various experiments in order to find out the reason why the reflection type magnetooptic sensor head according to Fig. 1 failed to detect light signals. Having made great many experiments, the inventors finally realized that the magnetic domain structure of the Faraday rotator was responsible for failing to detect light. That is, in Fig. 1, a Faraday rotator made of a multidomain element such as bismuth-substituted iron garnets could not detect light signals.

The result obtained by the inventors of the present invention does not agree to the experimental results obtained by Matsumura et al. who used YIG as a Faraday rotator which also has a multidomain structure. The inventors wondered why a bismuth-substituted iron garnet with multidomain did not properly function as a Faraday rotator in the reflection type magnetooptic sensor head built according to the construction in Fig. 1 similar to the YIG in Japanese Patent Publication No. 3-22595, while a YIG having a multidomain structure functioned properly as a Faraday rotator in Japanese Patent Publication No. 3-22595.

Having reviewed the aforementioned experimental results and making further basic experiments, the inventors confirmed that a reflection type magnetooptic sensor head can be constructed of a reflecting film, bismuth-substituted iron garnet single crystal film, polarizer, and light-inputting/outputting paths. Further, the light-inputting/outputting paths are divided into two light paths; an incoming-light path for the light coming into the polarizer from a light source and an outgoing light path for the light leaving the polarizer back to the light source. The two light paths are aligned their relative positions such that they make an angle greater than 5 degrees with each other. The inventors further continued the research work of magnetooptic sensor heads, and then developed a reflection type magnetooptic sensor head using a Faraday rotator made of a bismuth-substituted iron garnet as disclosed in Japanese Patent Application No.4-90976 (Fig. 2).

Fig. 2 shows the construction of a reflection type magnetooptic sensor head disclosed in Japanese Patent Application No. 4-90976. In Fig. 2, a polarizer depicted at 10 is, for example, POLARCORE (trade name, manufactured by CORNING). A Faraday rotator 11 is made of a bismuth-substituted iron garnet single crystal film which is magnetized most easily in a direction normal to the film surface. The Faraday rotator 11 is exposed to a magnetic field to be measured. A reflecting film 12 is formed of a dielectric multilayer. An optical waveguide 13 for an incoming lights is formed on glass or polymer, or is in the form of an optical fiber. An optical waveguide 14 for outgoing lights is formed on glass or polymer, or is in the form of an optical fiber.

In Fig. 2, the light emitted from a light source 16 such as a semiconductor laser, is directed through a lens 15 into the incoming light path 13. The lens 15 may be omitted so that the incoming light path 13 may be directly connected with the light source 16. The light exiting the light path 13 then passes through the polarizer 10, the Faraday rotator 11 to the reflecting film 12. The light is then reflected by the reflecting film 12 back through the Faraday rotator 11, the polarizer 10, the light path 14 to a photodetector 17 which detects the light signal. With the reflection type magnetooptic sensor head in Fig. 2, the light inputting/outputting port has two independent paths 13 and 14 which make an angle α greater than 5 degrees relative to each other.

The aforementioned reflection type magnetooptic sensors head using a Faraday rotator made of a bismuth-substituted iron garnet, adequately meet the requirements for a magnetooptic sensor head. However, they still need much technical improvements. For example, the two light paths must be aligned such that they make an angle α greater than 5 degrees with each other.

The inventors still carried out research work for further technical improvements in order to develop a general purpose, small, and high performance reflection type magnetooptic sensor head. The inventors realized that the input light path and output light path could be implemented in a single light path by positioning a Faraday rotator so that the Faraday rotator was at an angle with an axis normal to the polarizer, an axis normal to the reflector film, or the surface of the reflector.

Then, the inventors proposed in Japanese Patent Preliminary Publication No. 4-116141 that the aforementioned single light path could be implemented by allowing a light incident upon the surface of the bismuth-substituted iron garnet single crystal film to be at an angle from 10 to 70 degrees with an axis normal to the surface of the bismuth-substituted iron garnet single crystal film. However, this construction is disadvantageous in that the (111) bismuth-substituted iron garnet single crystal must be positioned at an angle with a light incident thereupon, being difficult to assemble and align a sensor head.

Then, the inventors proposed in Japanese Patent Application No. 4-142929 that the aforementioned single light path could easily be implemented by employing a Faraday rotator made of a bismuth-substituted iron garnet single crystal film having a [111] axis at an angle in the range from 5 to 60 degrees with an axis normal to the film surface. However, the inventors found that when the magnetooptic sensors are manufactured on a commercial basis, a very small percentages of a large number of sensors manufactured did not function properly. In other words, each and every one of a large number of sensors manufactured must be examined and inspected for possible defects.

It is cumbersome and uneconomical to carry out both function test and performance test on each and every one of the sensor products on a commercial basis, as well as to tilt the Faraday rotator and align the optical positional relation between the Faraday rotator and light paths. Still further research work by the inventors revealed that the optical position of a light path relative to the magnetic domain in the bismuth-substituted iron garnet single crystal film is responsible for insufficient performance of the sensors according to Japanese Patent Application No. 4-142929.

### SUMMARY OF THE INVENTION

An object of the invention is to provide a rotational speed measuring instrument which is small, light accurate, easy-to-use. Another object of the invention is to provide a rotational speed measuring instrument which provides reliability in long term use under severe environment such as vibrations and elevated temperatures. The inventors finally arrived at the conclusion that the fine optical alignment in assembling a Faraday rotator can be simplified by using a plurality of (111) bismuth-substituted iron garnets, which are selected from (111) bismuth-substituted iron garnet single crystal films whose [111] axes are substantially in line with geometric axes normal to the film surfaces and/or bismuth-substituted iron garnet single crystal films whose [111] axes are at angles in the range of 1-60 degrees with geometric axes normal to the film surfaces. In addition, the input light path and output light path can be implemented with a single light path.

In the present invention, light input/output path, polarizer, Faraday rotator, and reflecting film are aligned in order. The reflecting film is substantially perpendicular to the optical axis of the light input/output path.

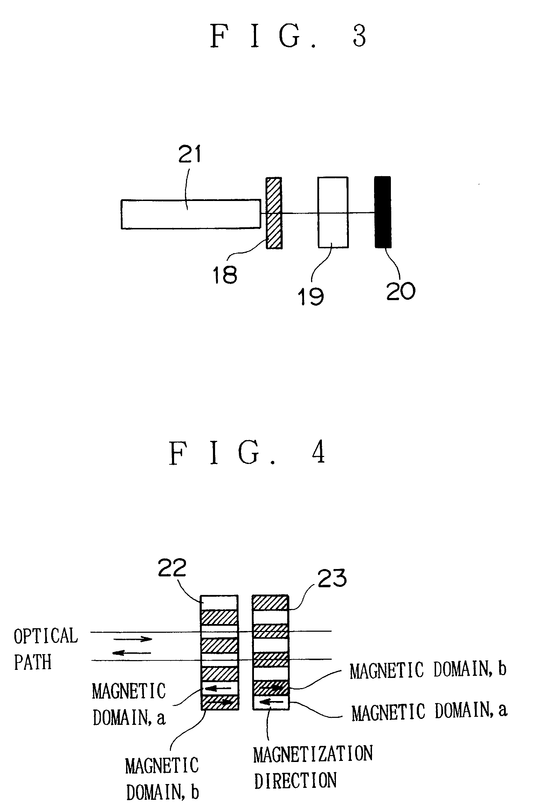

A reflection type magnetooptic sensor head based on a Faraday rotator made of a bismuth-substituted iron garnet according to the invention is constructed of a polarizer, a reflecting film, and a plurality of (111) bismuth-substituted iron garnet single crystal films. The plurality of (111) bismuth-substituted iron garnet single crystal films are arbitrarily selected from bismuth-substituted iron garnet single crystal films having a [111] axis at an angle in the range of 1-60 degrees with an axis normal to the film surface and (111) bismuth-substituted iron garnet single crystal films having a [111] axis in line with an axis normal to the film surface (Figs. 3-5).

In a reflection type magnetooptic sensor head according to the invention, a light inputting/outputting path, a polarizer, a plurality of bismuth-substituted iron garnet single crystal films in order as shown in Fig. 3.

### BRIEF DESCRIPTION OF THE DRAWINGS

Features and other objects of the invention will become more apparent from the description of the preferred embodiments with reference to the accompanying drawings in which:
Fig. 1 is an illustrative diagram showing a general construction of a reflection type magnetooptic sensor disclosed in Japanese Patent Publication No. 3-22595;
Fig. 2 is an illustrative diagram showing a general construction of a reflection type magnetooptic sensor head disclosed in Japanese Patent Application No. 4-90976;
Fig. 3 is an illustrative diagram showing a basic construction of a reflection type magnetooptic sensor according to the present invention:
Fig. 4 is an illustrative diagram showing the relation among the light path, position of magnetic domains and magnetization direction when a Faraday rotator was positioned perpendicularly to the light inputting/outputting path, the Faraday rotator being made of two (111) bismuth-substituted iron garnet single crystal films having a [111] axis in line with an axis normal to the film surface;

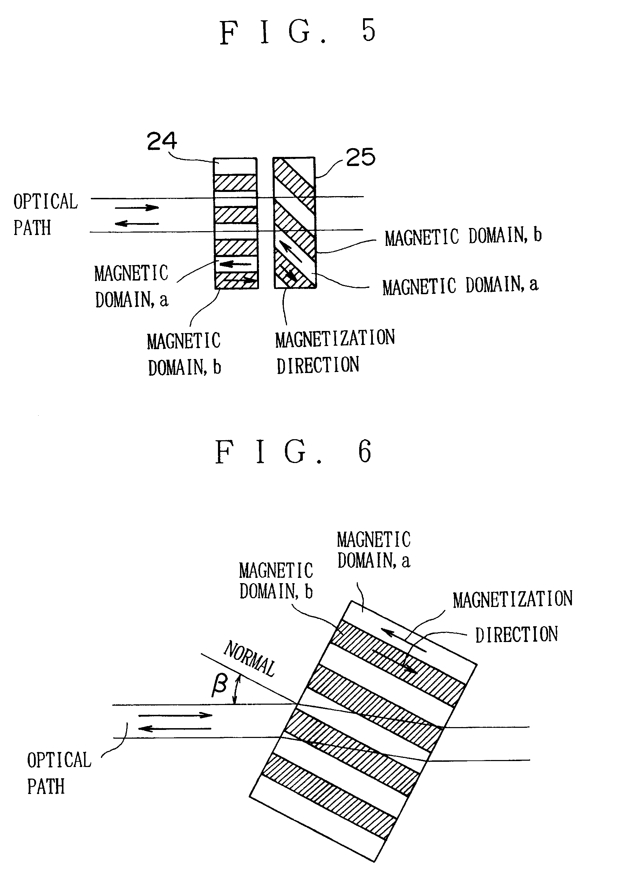

Fig. 5 is an illustrative diagram showing the relation among the light path, position of magnetic domains and magnetization direction when a Faraday rotator was positioned perpendicularly to the light inputting/outputting path, the Faraday rotator being made of two (111) bismuth-substituted iron garnet single crystal films one of which having a [111] axis at an angle with an axis normal to the film surface and the other of which having a [111] axis in line with an axis normal to the film surface;
Fig. 6 is an illustrative diagram showing the relation among the light path, position of magnetic domains and magnetization direction when a Faraday rotator was positioned at an angle with the optical axis of the light inputting/outputting path, the Faraday rotator being made of a (111) bismuth-substituted iron garnet single crystal films having a [111] axis in line with an axis normal to the film surface;

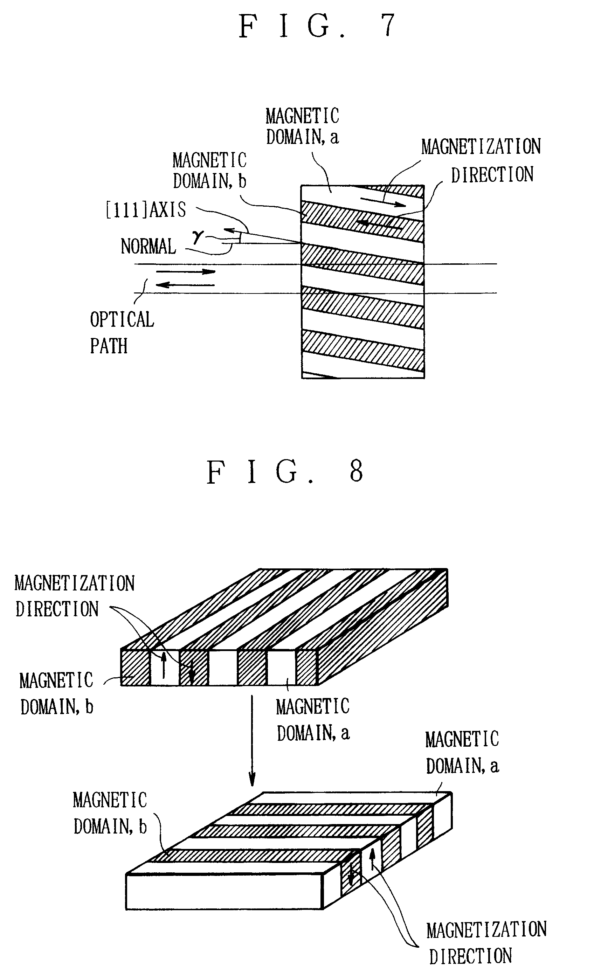

Fig. 7 is an illustrative diagram showing the relation among the light path, position of magnetic domains and magnetization direction when a Faraday rotator was positioned perpendicularly relative to the optical axis of the light inputting/outputting path, the Faraday rotator being made of a (111) bismuth-substituted iron garnet single crystal films having a [111] axis at an angle with an axis normal to the film surface; and
Fig. 8 is an illustrative diagram showing the relation among the light path, position of magnetic domains and magnetization direction when a Faraday rotator was positioned perpendicularly relative to the optical axis of the light inputting/outputting path, the Faraday rotator being made of a (111) bismuth-substituted iron garnet single crystal film having a [111] axis at an angle wit an axis normal to the film surface; and

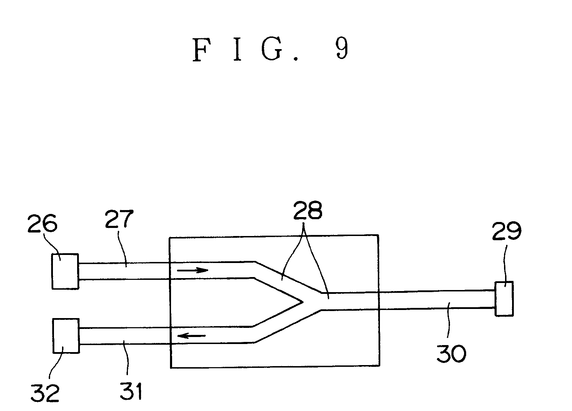

Fig. 9 is an illustrative diagram showing a general construction of a magnetooptic sensor based on a reflection type magnetooptic sensor head according to the invention.

### DETAILED DESCRIPTION OF THE EMBODIMENTS

The present invention will now be described in detail by way of specific examples as follows:
Fig. 3 illustrates a general construction of a reflection type magnetooptic sensor head according to the invention, which includes a polarizer 18 in the form of, for example, POLARCORE, Faraday rotator 19 made of a plurality of bismuth-substituted iron garnet single crystal films, reflecting film 20 such as metal thin film, and input/output light paths 21 in the form of optical fiber or optical guide. The input/output light paths 21 may be arranged so that it not only functions as a light path but also serve as a light-branching element for guiding the signal light reflected back by the reflecting film 20 into the photodetector (Fig. 9).

With a reflection type magnetooptic sensor using a Faraday rotator made of a bismuth-substituted iron garnet single crystal film having a multidomain structure, it is necessary that the light transmitted through the Faraday rotator toward the reflecting film passes through magnetic domains different from those through which the light reflected back by the reflecting film passes (Japanese Patent Applications No. 4-090976 in Fig. 6 and No. 4-116141 in Fig. 7).

Insufficient performance of the sensors manufactured according to Japanese Patent Application No. 4-142929 is due to the fact that the light transmitted through the Faraday rotator toward the reflecting film does not pass through magnetic domains different from those through which the light reflected back by the reflecting film passes.

Figs. 4 and 5 illustrate the Faraday rotator according to the present invention which is formed of two or more bismuth-substituted iron garnet single crystal. Implementing a Faraday rotator with a plurality of bismuth-substituted iron garnet single crystal placed together provides as good Faraday effect as that resulted from a tilted Faraday rotator or a Faraday rotator made of a bismuth-substituted iron garnet single crystal having a [111] axis at an angle with an axis normal to the film surface. In other words, passing through a plurality of bismuth-substituted iron garnet single crystal films provides an effect equivalent to passing through different magnetic domains, i.e., magnetic domains a and b of one crystal film.

This is explained in more specifically by referring to Fig. 4. The light signal first passes through the magnetic domain a of a first bismuth-substituted iron garnet single crystal 22, and then through the magnetic domain b of a second bismuth-substituted iron garnet single crystal 23. The light passes through magnetic domains a and b while it travels back and forth through the two Faraday rotators 22 and 23. This provides as good effect as when a Faraday rotator is tilted with respect to the optical axis of the light incident upon the Faraday rotator or when a bismuth-substituted iron garnet single crystal film having a [111] axis at an angle with an axis normal to the film surface was used.

The Faraday rotator shown in Fig. 4 is implemented by a bismuth-substituted iron garnet single crystal film where [111] axis is in line with an axis normal to the film surface. Thus, the optical axis of the light incident upon the film surface is parallel with magnetization direction. This indicates that a plurality of layers must be aligned so that the magnetic domains a or b of the preceding layer are opposed to the magnetic domains b or a of the following layer. The more number of layers, the more chances that the light passes through different magnetic domains. However, the number of layers is practically limited by production economy. Implementing a Faraday rotator with the least number of layers, yet allowing the light to pass through different magnetic domains a and b with high accuracy and probability, will eliminate cumbersome, fine adjustment and alignment of structural elements of the Faraday rotator.

In another embodiment of the invention shown in Fig. 5, the Faraday rotator is formed of two types of bismuth-substituted iron garnet single crystal films; one is a bismuth-substituted single crystal film having a [111] axis at an angle of 1-60 degrees with an axis normal to the film surface and the other is a (111) bismuth-substituted single crystal film having a [111] axis is in line with an axis normal to the film surface. This construction eliminates the need for tilting the Faraday rotator or cumbersome fine adjustment of the sensor components, thus virtually no chance of resulting defective sensor heads in the production line. This construction enables the light to undergo different magnetic domains a and b with high possibility and accuracy.

Figs. 3 and 5 illustrates an example of two bismuth-substituted iron garnet single crystal films placed together. A (111) bismuth-substituted iron garnet single crystal 24 has a [111] axis in line with an axis normal to the film surface, and a bismuth-substituted iron garnet single crystal 25 has a [111] axis at an angle of 1-60 degrees with an axis normal to the film surface. A light first passes through the magnetic domains a of the crystal 24 and then through the magnetic domains b of the crystal 25, and is reflected back by the reflecting film 20. The reflected light first passes through the magnetic domains b and then passes through the magnetic domains a. This construction allows the light to pass through different magnetic domains a and b while the light passing back and forth through the crystals 24 and 25.

In the present invention, a Faraday rotator must be constructed of a plurality of bismuth-substituted iron garnet single crystal films of the same type or of an arbitrary combination of different types. The bismuth-substituted iron garnet single crystal films include a plurality of bismuth-substituted single crystal films having a [111] axis at an angle of 1-60 degrees with an axis normal to the film surface and a (111) bismuth-substituted iron garnet single crystal films having a [111] axis in line with an axis normal to the film surface. For best performance and yield of products, the Faraday rotator is preferably a combination of bismuth-substituted iron garnet single crystal films having a [111] axis at an angle of 1-60 degrees with an axis normal to the film surface and (111) bismuth-substituted iron garnet single crystal films having a [111] axis in line with an axis normal to the film surface. However, there is no particular limitation on the position of the layers relative to the light source, the combination of the layers, and the number of (111) bismuth-substituted iron garnet single crystal films. Therefore, the types of bismuth-substituted iron garnet single crystal film and the number of film layers are determined taking the required performance and characteristics of the Faraday rotator into consideration.

General purpose magnetooptic sensor heads can be manufactured by combining two layers of the same type selected from either bismuth-substituted single crystal films having a [111] axis at an angle of 1-60 degrees with an axis normal to the film surface or (111) bismuth-substituted iron garnet single crystal films having a [111] axis in line with an axis normal to the film surface.

For special purposes, the magnetooptic sensor heads are preferably manufactured by combining two layers of the same type or different types selected from a bismuth-substituted iron garnet single crystal films having a [111] axis at an angle of 1-60 degrees with an axis normal to the film surface and a (111) bismuth-substituted iron garnet single crystal films having a [111] axis in line with an axis normal to the film surface. The number of crystals may be selected as required. A three-layer construction where a bismuth-substituted iron garnet is formed on both sides of a non-magnetic garnet substrate, may also be employed.

When manufacturing a magnetic sensor head according to the present invention, there is no particular restriction on the compound of a bismuth-substituted iron garnet. However, it is preferable to select from iron garnet single crystals given by a general equation:

R₃₋ₓBiₓFe_{5-z}A_{z}O₁₂

where R is at least one of Y, La, Ce, Pr, Nd, Sm, Eu, Gd, Tb, Dy, Ho, Er, Tm, Yb, and Lu, and A is at least one of Ga, Sc, Al, and In, and 0.3≦x≦2.0 and 0≦z≦1.0.

A bismuth-substituted iron garnet single crystal of the invention can easily be manufactured by using different substrates by the LPE method (Thin Solid Films, Vol.114, p33(1984)). Although any known substrate may be used for growing a single crystal thereon by the LPE method, a non-magnetic garnet [(GdCa)₃(GaMgZr)₅O₁₂] referred to as an SGGG substrate is preferably used which has a lattice constant of 12.490-12.515 angstroms and is available as a substrate for LPE on the market.

A (111) bismuth-substituted iron garnet single crystal film is manufactured by growing a bismuth-substituted iron garnet single crystal film on a non-magnetic garnet substrate having a [111] axis in line with an axis normal to the film surface by the liquid phase epitaxial (LPE) method.

A non-magnetic substrate having a [111] axis at an angle γ with an axis normal to the film surface can be used as a substrate for growing a single crystal to manufacture a (111) bismuth-substituted iron garnet single crystal film having a [111] axis at an angle γ with an axis normal to the film surface.

Growing a bismuth-substituted single crystal film on a non-magnetic garnet substrate having a [111] axis at an angle with an axis normal to the film surface by the LPE method, provides a bismuth-substituted iron garnet single crystal having a [111] at an angle of 1-60 degrees with an axis normal to the film surface. The angle which the [111] axis of the thus manufactured bismuth-substituted iron garnet single crystal film makes with the film surface thereof, is greater than or as large as that of the substrate for growing single crystal.

A non-magnetic substrate garnet having a [111] axis at an angle γ with an axis normal to the film surface can be manufactured by cutting an ingot of the non-magnetic garnet substrate at a desired γ. The larger the angle γ, the less number of substrates manufactured from an ingot and the higher cost of the substrate. Thus, angle γ should be practically as small as possible from a point of view of production economy. In the present invention, the angle γ is in the range of 1-60 degrees and more preferably 3-45 degrees. If production economy is of prime importance, the angle γ may be in the range of 3-20 degrees.

Angles γ less than 1 degree will not exhibit significant effect of tilting a [111] axis relative to an axis normal to the film surface. That is, the result has little or no difference as compared to that of a Faraday rotator made of a plurality of (111) bismuth-substituted iron garnet single crystal film whose [111] axes are substantially oriented in the same direction. On the other hand, angles γ greater than 45 degrees, particularly angles greater than 60 degrees, result uneconomical production.

There is no particular requirement for implementing the present invention as far as a Faraday rotator is made of a bismuth-substituted iron garnet single crystal film having a [111] axis at an angle of 1-60 degrees with an axis normal to the film surface and/or a (111) bismuth-substituted iron garnet single crystal having a [111] axis substantially in line with an axis normal to the film surface as well as crystal films are arranged so that light passes through the magnetic domain patterns and magnetic domain widths of the films to effectively develop rotation of polarization plane.

A bismuth-substituted iron garnet single crystal film having a [111] axis at an angle in the range of 1-60 degrees with an axis normal to the film surface may one of the followings.
(1) A layered structure of a plurality of bismuth-substituted iron garnet single crystal films having a [111] axis at angles in the range of 1-60 degrees with an axis normal to the film surface.
(2) A three-layer bismuth-substituted iron garnet single crystal grown on two sides of a non-magnetic garnet substrate, and having a [111] axis at angles in the range of 1-60 degrees.
(3) A layered structure of arbitrary combination of a bismuth-substituted iron garnet single crystal films having a [111] axis at angles in the range of 1-60 degrees with an axis normal to the film surface, and a three-layer bismuth-substituted iron garnet single crystal grown on two opposed sides of a non-magnetic garnet substrate and having a [111] axis angles in the range of 1-60 degrees.
   Further, the (111) bismuth-substituted iron garnet single crystal film having a [111] axis substantially in line with an axis normal to the film surface may be one of the followings.
(4) A layered structure of a plurality of (111) bismuth-substituted iron garnet single crystal films having a [111] axis substantially in line with an axis normal to the film surface.
(5) A three-layer bismuth-substituted iron garnet single crystal grown on two opposed sides of a non-magnetic garnet substrate, having a [111] axis in line with an axis normal to the film surface.
(6) A layered structure of arbitrary combination of a bismuth-substituted iron garnet single crystal films having a [111] axis substantially in line with an axis normal to the film surface, and a three-layer bismuth-substituted iron garnet single crystal grown on two opposed sides of a non-magnetic garnet substrate, having a [111] axis in line with an axis normal to the film surface.

Bismuth-substituted iron garnet films having linear magnetic domain patterns on the film surface are preferably placed closely together or with an air gap therebetween so that the linear patterns cross each other as shown in Fig. 8. Alternatively, bismuth-substituted iron garnets having different magnetic domain widths may be placed closely together or with an air gap therebetween. However, bismuth-substituted iron garnet films having the same magnetic domain width and magnetic domain pattern of maze, result in overlapped magnetic domains when placed closely together. Therefore, such crystal films should be arranged a predetermined distance away from each other, specifically about 400 µm. The magnetooptic sensor constructed in this manner, satisfies a requirement of a difference ΔP in intensity of at least 2 dB (Japanese Patent Application No. 4-90976.)

In the present invention, there is no particular requirement of an angular position of a bismuth-substituted iron garnet single crystal relative to the optical axis of an optical path. When the surface of bismuth-substituted iron garnet single crystal reflects light to seriously affect measurement, the bismuth-substituted iron garnet single crystal is preferably tilted to prevent the stray light from directly returning to the inputting/outputting light path. When a bismuth-substituted iron garnet single crystal is applied with an antireflection film thereon which sufficiently reduces surface reflection, the bismuth-substituted iron garnet single crystal film is preferably positioned so that the film is substantially perpendicular to the optical path.

In the present invention, the analyzer may be any type of analyzer available on the market whatever suitable for a specific purpose. A dichroic polarizer is preferably used for small thickness and high extinction.

There is no particular requirement for the reflecting film. It is preferred to use a mirror made of a metal film deposited on glass available on the market, a bismuth-substituted iron garnet thin film, metallic mirror made by depositing gold or aluminum directly on a non-magnetic garnet substrate, or dielectric multilayer mirror made or multilayer of metal oxides such as SiO₂ and TiO₂.

The light inputting/outputting path do not have to be of a special type. The light inputting/outputting path may be an optical fiber and the light outputting path may be air and optical wave guides patterned on glass or polymer film, rand optical fibers are particularly preferred for mass production and miniaturization of sensors.

Any type of optical fiber may be used for the light inputting/outputting path, but those having core diameters less than 50 µm causes the width of magnetic domain of a bismuth-substituted iron garnet to affect the characteristics of a sensor, resulting in unstable sensitivity and lower optical coupling efficiency. Diameters greater than 50 µm are sufficient.

The reflection type magnetooptic sensor head according to the present invention is connected to a light source and a photodetector through the use of a half mirror shown in Fig. 1 or an optical branching device such as optical wave guides and optical couplers as shown in Fig. 9. In Fig. 9, a light emitted from a light source 26 such as a semiconductor laser is transmitted through optical fibers 27 and 30 via an optical wave guide 28 formed on glass or polymer. The light then enters a magnetooptic sensor head made up of a polarizer, a plurality of bismuth-substituted iron garnet, and reflecting film. The reflected back from the reflecting film is transmitted through the optical fibers 30 and 31 via the optical guide 28 into a photodetector 32 (power meter). If desired, part of the optical fibers may be omitted or the reflection type magnetooptic sensor head may be directly connected to the optical guide.

The wavelength of a light source of a magnetooptic measuring apparatus is selected taking into account the sensitivity and light transmittance of a Faraday rotator, the performance and cost of a light source, and the sensitivity of a detector. The wavelength of a light source is preferably selected from near infrared lights in the range from 780 to 850 for the following reasons.
(1) A bismuth-substituted iron garnet includes regions called "window" where optical absorption coefficient is relatively small.
(2) The Faraday effect of a bismuth-substituted iron garnet is large.
(3) A bismuth-substituted iron garnet has film thickness from 30 to 100 µm and is easy to manufacture.
(4) Short wavelength semiconductor lasers and light emitting diodes of high output are commercially available at low costs.
(5) The photodetector is highly sensitive and is available at low costs.

Preferable second alternative wavelengths are in the 1300 nm band and 1550 nm band used in optical fiber communications, or 1060 nm at which YAG lasers can be used.

Wavelengths beyond these ranges result in higher optical absorption and smaller Faraday effect of a bismuth-substituted iron garnet, causing difficulty in detecting light signals and requiring larger thickness of Faraday rotators.

Embodiments of the present invention will be described below in detail with reference to the drawings. The examples are exemplary and do not limit the scope of the invention.

### Example 1

A one-inch garnet single crystal [(GdCa)₃(GaMgZr)₅O₁₂], which is an ingot manufactured by the Czochralski method and has a lattice constant equal to 12.498±0.002 angstroms, was cut by a conventional method into substrates so that the [111] axis of the substrate makes an angle of 5 degrees with an axis normal to the surface of the substrate. A crystal film obtained is a 490-510 µm thick substrate having a [111] axis at an angle of 5 degrees with an axis normal to the film surface. This substrate is referred to as substarate [a1] in the present invention and is used for growing a single crystal thereon. Likewise, a crystal film obtained is a 480-500 µm thick substrate having a [111] axis in line with an axis normal to the film surface. This substrate is referred to as substrate [b1] and is used for growing a single crystal thereon.

The magnetooptic sensor head was manufactured in the following manner.

A 500 milliliter platinum crucible was placed on an LPE furnace, which platinum crucible contained therein a lead oxide (PbO, 4N) of 843 grams, a bismuth oxide (Bi₂O₃, 4N) of 978 grams, a ferric oxide (Fe₂O₃, 4N) of 128 grams, a boron oxide (B₂O₃, 5N) of 38 grams, a terbium oxide (Tb₄O₇, 3N) of 4.0 grams, and a holmium oxide (Ho₂O₃, 3N) of 9.0 grams. The content of the crucible was heated to a temperature of 1000 degrees Celsius. The melted content was sufficiently beaten for a homogeneous mixture and was then cooled down to a melt temperature of 768 degrees Celsius to produce a melt for growing a bismuth-substituted iron garnet single crystal.

Then, using a known procedure, the substrates [a1] and [b1] are immersed in the melt for 0.5 hour for epitaxial growth while maintaining the melt at 768 degrees Celsius. A single crystal obtained was a Ho_{1.1}Tb_{0.6}Bi_{1.3}Fe₅O₁₂ single crystal (referred to as HoTbBiIG single crystal [A1] hereafter) having a Ho_{1.1}Tb_{0.6}Bi_{1.3}Fe₅O₁₂ single crystal film on two opposed sides having a [111] axis at an angle of 5 degrees with an axis normal to the film surface. Another single crystal obtained was a Ho_{1.1}Tb_{0.6}Bi_{1.3}Fe₅O₁₂ single crystal (referred to as HoTbBiIG single crystal [B1] hereafter) having a Ho_{1.1}Tb_{0.6}Bi_{1.3}Fe₅O₁₂ single crystal film on two opposed sides having a [111] axis in line with an axis normal to the film surface.

The HoTbBiIG single crystal [A1] has a thickness of 12 µm on each of opposed sides, a Faraday rotation Θ_{F} of 22.2 degrees at a wavelength of 786 nm, and a magnetic saturation at 1000 Oe. The HoTbBiIG single crystal B1 has a thickness of 13 µm on each of opposed sides, a Faraday rotation Θ_{F} of 23.1 degrees at a wavelength of 786 nm, and a magnetic saturation at 1000 Oe.

Then, the HoTbBiIG single crystal [A1] was deposited with aluminum on one side thereof by vacuum evaporation to form a reflecting film, or mirror and was applied with an antireflection film on the other side by a conventional method. Then, the HoTbBiIG single crystal [A1] was cut into a desired size of 2.5 mm by 2.5 mm, thereby providing a HoTbBiIG single crystal [A1]/reflecting film block.

Then, the HoTbBiIG single crystal [B1] was deposited with an antireflection film on each of opposed sides thereof by a conventional method, and was then cut into a desired size of 2.5 mm by 2.5 mm to provide a piece of HoTbBiIG single crystal [B1]. Thereafter, the HoTbBiIG single crystal [B1] and the HoTbBiIG single crystal [A1]-reflecting film block were placed together using an optical adhesive available on the market so that the HoTbBiIG single crystal [B1] was in contact with the HoTbBiIG single crystal film side of the HoTbBiIG single crystal [A1]-reflecting film block. This provides a Faraday rotator-reflecting film block.

Arbitrary five blocks of the thus manufactured Faraday rotator-reflecting film blocks were picked out, and a polarizer (trade name is POLARCORE, manufactured by CORNING) having an antireflection film applied thereon was mounted on the HoTbBiIG single crystal surface of each block. The polarizer was then securely bonded by an epoxy adhesive to complete a polarizer-Faraday rotator [A1-B1]-reflecting film block. This block was then mounted to a polymer-clad optical fiber having a diameter of 400 µm to provide a magnetooptic sensor head. This optical fiber serves as a light inputting/outputting path.

The thus manufactured magnetooptic sensor head was mounted to a magnetooptic sensor head terminals of a reflection type magnetooptic sensor shown in Fig. 1. The tip end portion of the magnetooptic sensor head was then placed in position within a magnetic field applying apparatus (trade name is MAGNET, manufactured by MAGNETICS).

A light source 1 (semiconductor laser, trade name is Model LT024MD/PD SEMICONDUCTOR LASER, manufactured by Sharp) emits a light having a wavelength of 0.786 µm. The light was transmitted through a lens 2, half mirror 3, light inputting/outputting path 4 having a 400 µm core diameter to the magnetooptic sensor head 5,6,7, and 8. Then, the light was reflected back by the magnetooptic sensor head along the optical fiber 4 to a photodetector 9 (trade name is Model AQ-1111 POWER METER manufactured by Ando Denki), which in turn measured the intensity of the light. The Faraday rotator was magnetically saturated when applied with a magnetic field of 1000 Oe. The difference in light intensity between when the Faraday rotator was applied with a magnetic field of 1000 Oe and when no magnetic field was applied, was in the range of 2.5-2.6 dB and 2.5 dB on average.

### Example 2

A Ho_{1.1}Tb_{0.6}Bi_{1.3}Fe₅O₁₂ single crystal (referred to as HoTbBiFeO [A2]) having a Ho_{1.1}Tb_{0.6}Bi_{1.3}Fe₅O₁₂ crystal film was manufactured in the same way as in Example 1 except that a 1-hour epitaxial growth was carried with one side of the substrate [a1] in contact with the surface of the melt for growing single crystal. The thus manufactured HoTbBiFeO crystal [A2] has a film thickness of 23 µm and a Faraday rotation Θ_{F} at saturated magnetization was 21.7 degrees at a wavelength of 786 nm.

Aluminum was deposited on the surface of the substrate [a1] of the HoTbBiIG crystal [A2] by vacuum evaporation to form a reflecting film or mirror and then an antireflection film was applied on the surface of the HoTbBiIG crystal. Then, the substrate was cut to provide HoTbBiIG single crystal [A2]-reflecting film blocks having a predetermined size of 2.5 mm by 2.5 mm.

Arbitrary five blocks of the thus manufactured HoTbBiIG single crystal [A2]-reflecting film blocks were picked out. The HoTbBiIG single crystal [B1] and the HoTbBiIG single crystal [A2]-reflecting film block were placed together so that the HoTbBiIG single crystal [B1] was in close contact with the HoTbBiIG single crystal surface of the HoTbBiIG single crystal [A2]-reflecting film block. The HoTbBiIG single crystal [B1] was then securely bonded by an optical bonding agent available on the market. Then, a polarizer (trade name is POLARCORE manufactured by CORNING) having an antireflection film applied thereon was mounted to the surface of the HoTbBiIG single crystal [B1] and was then bonded by an epoxy adhesive to provide a polarizer-Faraday rotator [A2-B1]-reflecting film block. The thus manufactured polarizer-Faraday rotator [A2-B1]-reflecting film block was mounted thereto an optical fiber having a diameter of 400 µm to form a magnetooptic sensor head. This optical fiber serves as a light inputting/outputting path.

The magnetooptic sensor head of Example 2 was mounted to the magnetooptic sensor head terminal of the apparatus used in Example 1 and the performance of the Faraday rotator was examined in a similar way to Example 1.

The Faraday rotator was magnetically saturated when applied with a magnetic field of 1000 Oe. The difference in light intensity between when the Faraday rotator was applied with a magnetic field of 1000 Oe and when no magnetic field was applied, was in the range of 2.8-3.0 dB and 2.5 dB on average.

### Example 3

A magnetooptic sensor head was manufactured in the same way as in Example 1 except that an ingot was cut into substrates so that the [111] axis of the substrate makes an angle of 3 degrees with the an axis normal to the surface of the substrate. This substrate is referred to as substrate [a3] in the present invention. The Faraday rotator [A3-B1] was magnetically saturated when applied with a magnetic field of 1000 Oe. The difference in light intensity between when the Faraday rotator was applied with a magnetic field of 1000 Oe and when no magnetic field was applied, was in the range of 2.2-2.5 dB and 2.3 dB on average.

### Example 4

A magnetooptic sensor head was manufactured in the same way as in Example 1 except that an ingot was cut into substrates so that the [111] axis of the substrate makes an angle of 10 degrees with the an axis normal to the surface of the substrate. This substrate is referred to as substrate [a4] in the present invention. The Faraday rotator [A4-B1] was magnetically saturated when applied with a magnetic field of 1000 Oe. The difference in light intensity between when the Faraday rotator was applied with a magnetic field of 1000 Oe and when no magnetic field was applied, was in the range of 2.8-3.3 dB and 3.0 dB on average.

### Example 5

A magnetooptic sensor head was manufactured in the same way as in Example 1 except that an ingot was cut substrates so that the [111] axis of the substrate makes an angle of 20 degrees with the an axis normal to the surface of the substrate. This substrate is referred to as substrate [a5] in the present invention. The Faraday rotator [A5-B1] was magnetically saturated when applied with a magnetic field of 1000 Oe. The difference in light intensity between when the Faraday rotator was applied with a magnetic field of 1000 Oe and when no magnetic field was applied, was in the range of 3.0-3.4 dB and 3.2 dB on average.

### Example 6

A magnetooptic sensor head was manufactured in the same way as in Example 1 except that an ingot was cut into substrates so that the [111] axis of the substrate makes an angle of 40 degrees with the an axis normal to the film surface. This substrate is referred to as [a6] in the invention. The Faraday rotator [A6-B1] was magnetically saturated when applied with a magnetic field of 1000 Oe. The difference in light intensity between when the Faraday rotator was applied with a magnetic field of 1000 Oe and when no magnetic field was applied, was in the range of 3.6-4.1 dB and 3.8 dB on average.

### Example 7

A magnetooptic sensor head was manufactured in the same way as in Example 1 except that an ingot was cut into substrates so that the [111] axis of the substrate makes an angle of 60 degrees with the an axis normal to the surface of the substrate. This substrate is referred to as substrate [a7] in the present invention. This substrate is referred to as substrate [a7] in the present invention. The Faraday rotator [A7-B1] was magnetically saturated when applied with a magnetic field of 1000 Oe. The difference in light intensity between when the Faraday rotator was applied with a magnetic field of 1000 Oe and when no magnetic field was applied, was in the range of 3.3-3.5 dB and 3.4 dB on average.

### Example 8

A magnetooptic sensor head was manufactured in the following manner.

A 500 milliliter platinum crucible was placed on an LPE furnace, which platinum crucible contained therein a lead oxide (PbO, 4N) of 843 grams, a bismuth oxide (Bi₂O₃, 4N) of 978 grams, a ferric oxide (Fe₂O₃, 4N) of 120 grams, a gallium oxide (Ga₂O₃, 4N) of 4.5 grams, boron oxide (B₂O₃, 5N) of 38 grams, a gadolinium oxide (Gd₂O₃, 3N) of 6.5 grams, and yttrium oxide (Y₂O₃, 3N) of 4.0 grams. The content of the crucible was heated to a temperature of 1000 degrees Celsius. The melted content was sufficiently beaten for a homogeneous mixture and was then cooled down to a melt temperature of 773 degrees Celsius to produce a melt for growing a bismuth-substituted iron garnet single crystal.

Then, using a known procedure, the substrate [b1] manufactured in Example 1 was immersed in the melt for 0.7 hour for epitaxial growth while maintaining the melt at 773 degrees Celsius. A single crystal obtained was a Y_{0.9}Gd_{0.9}Bi_{1.2}Fe_{4.8}Ga_{0.2}O₁₂ single crystal (referred to as YGdBiGaIG single crystal [B2] hereafter) having a Y_{0.9}Gd_{0.9}Bi_{1.2}Fe_{4.8}Ga_{0.2}O₁₂ single crystal film on two opposed sides.

The YGdBiGaIG single crystal [B2] has a thickness of 16 µm on each side, a Faraday rotation Θ_{F} of 24.4 degrees at a wavelength of 786 nm, and a saturated magnetization of 600 Oe.

Then, the YGdBiGaIG single crystal was applied with an antireflection film on each of opposed sides before being cut into pieces of YGdBiGaIG single crystal of a predetermined size of 2.5 mm by 2.5 mm.

Arbitrary five blocks of the thus manufactured YGdBiGaIG single crystals [B2] were picked out. The YGdBiGaIG single crystals [B2] and the HoTbBiIG single crystal [A1]-reflecting film block manufactured in Example 1 were placed together so that the YGdBiGaIG single crystal [B2] was in close contact with the HoTbBiIG single crystal film surface of the HoTbBiIG single crystal [A1]-reflecting film block, and were then bonded together using an optical bonding agent available on the market. Then, a polarizer (trade name is POLARCORE, manufactured by CORNING) having an antireflection film applied thereon was mounted on the surface of the YGdBiGaIG single crystal [B2]. The polarizer was then securely bonded by an epoxy adhesive to complete a polarizer-Faraday rotator[A1-B2]-reflecting film block. This block was then mounted to a polymer-clad optical fiber having a diameter of 400 µm to provide a magnetooptic sensor head. This optical fiber serves as a light inputting/outputting path.

The thus manufactured magnetooptic sensor head was mounted to the light inputting/outputting path of a magnetooptic sensor, which includes a light branching device (Model 200S2-D2, manufactured by Mitsubishi Gasu Kagaku) in the form of a polymer optical guide (Fig. 9). The light inputting/outputting path is an optical fiber having a core diameter of 200 µm. The tip end portion of the magnetooptic sensor head was placed in position within a magnetic field applying apparatus (trade name is MAGNET, manufactured by MAGNETICS).

For various magnetic fields applied to the magnetooptic sensor head, the light intensity of a single light entering the photodetector (trade name is Model AQ-111 POWER METER, manufactured by Ando Electric.) was measured at a wavelength of 0.786 µm. The Faraday rotator was magnetically saturated in a magnetic field of 1000 Oe. The difference in light intensity between when the Faraday rotator is applied with a magnetic field of 1000 Oe and when not applied, was in the range of 3.5-3.8 dB and 3.7 on average.

### Example 9

A magnetooptic sensor head was manufactured in the same way as in Example 8 except that the HoTbBiIG single crystal [A3]-reflecting film block manufactured in Example 3 was used in place of the HoTbBiIG single crystal [A1]-reflecting film block manufactured in Example 1. Then, the performance of the Faraday rotator was examined in a similar way to Example 8. The Faraday rotator [A3-B2] was magnetically saturated in a magnetic field of 1000 Oe. The difference in light intensity between when the Faraday rotator was applied with a magnetic field of 1000 Oe and when no magnetic field was applied, was in the range of 3.0-3.5 dB and 3.3 dB on average.

### Example 10

A magnetooptic sensor head was manufactured in the same way as in Example 8 except that the HoTbBiIG single crystal [A7]-reflecting film block manufactured in EXample 7 was used in place of the HoTbBiIG single crystal [A1]-reflecting film block manufactured in Example 1. Then, the performance of the Faraday rotator was examined in a similar way to Example 8. The Faraday rotator [A7-B2] was magnetically saturated in a magnetic field of 1000 Oe. The difference in light intensity between when the Faraday rotator was applied with a magnetic field of 1000 Oe and when no magnetic field was applied, was in the range of 2.7-3.1 dB and 2.8 dB on average.

### Example 11

A magnetooptic sensor head was manufactured in the following manner.

A 500 milliliter platinum crucible was placed on an LPE furnace, which platinum crucible contained therein a lead oxide (PbO, 4N) of 843 grams, a bismuth oxide (Bi₂O₃, 4N) of 978 grams, a ferric oxide (Fe₂O₃, 4N) of 120 grams, a gallium oxide (Ga₂O₃, 4N) of 4.5 grams, boron oxide (B₂O₃, 5N) of 38 grams, a gadolinium oxide (Gd₂O₃, 3N) of 6.5 grams, and yttrium oxide (Y₂O₃, 3N) of 4.0 grams. The content of the crucible was heated to a temperature of 1000 degrees Celsius so that the content in the crucible melts. The melted content was sufficiently beaten for a homogeneous mixture and was then cooled down to a melt temperature of 773 degrees Celsius to produce a melt for growing a bismuth-substituted iron garnet single crystal.

Then, using a known procedure, the substrate [a1] manufactured in Example 1 was immersed in the melt for 0.7 hour for epitaxial growth while maintaining the melt at 773 degrees Celsius. A single crystal obtained was a Y_{0.9}Gd_{0.9}Bi_{1.2}Fe_{4.8}Ga_{0.2}O₁₂ single crystal (referred to as YGdBiGaIG single crystal [A8] hereafter) having a Y_{0.9}Gd_{0.9}Bi_{1.2}Fe_{4.8}Ga_{0.2}O₁₂ single crystal film on two opposed sides thereof. The obtained crystal has a [111] axis at an angle of 5 degrees with an axis normal to the film surface.

The YGdBiGaIG single crystal [A8] has a thickness of 15 µm on each of the opposed sides, a Faraday rotation Θ_{F} of 23.7 degrees at a wavelength of 786 nm, and a saturated magnetization of 600 Oe.

Then, the YGdBiGaIG single crystal [A8] was deposited with aluminum by vacuum evaporation to form a reflecting film or mirror on one side thereof and was applied with an antireflection film on the other side using a conventional method. Then, the YGdBiGaIG single crystal [A8] was cut into pieces of a predetermined size of 2.5 mm by 2.5 mm, thereby providing YGdBiGaIG single crystal [A8]-reflecting film block.

Arbitrary five blocks of the thus manufactured YGdBiGaIG single crystal [A8]-reflecting film blocks were picked out. A polarizer (trade name is POLARCORE, manufactured by CORNING) having an antireflection film applied thereon was mounted on the YGdBiGaIG single crystal surface of each block. Then, a polarizer (trade name is POLARCORE manufactured by CORNING) applied with an antireflection film was then securely bonded by an epoxy adhesive to provide a polarizer-Faraday rotator [A8-B2]-reflecting film block. The performance of the thus made Faraday rotator was examined in a similar way to Example 8. The Faraday rotator [A8-B2] was magnetically saturated in a magnetic field of 600 Oe. The difference in light intensity between when the Faraday rotator was applied with a magnetic field of 600 Oe and when no magnetic field was applied, was in the range of 4.5-4.6 dB and 4.6 dB on average.

### Example 12

A magnetooptic sensor head was manufactured in the following manner.

A 500 milliliter platinum crucible was placed on an LPE furnace, which platinum crucible contained therein a lead oxide (PbO, 4N) of 843 grams, a bismuth oxide (Bi₂O₃, 4N) of 978 grams, a ferric oxide (Fe₂O₃, 4N) of 128 grams, a boron oxide (B₂O₃, 5N) of 38 grams, a terbium oxide (Tb₄O₇, 3N) of 4.0 grams, and holmium oxide (Ho₂O₃, 3N) of 9.0 grams. The content of the crucible was heated to a temperature of 1000 degrees Celsius so that the content in the crucible melts. The melted content was sufficiently beaten for a homogeneous mixture and was then cooled down to a melt temperature of 770 degrees Celsius to produce a melt for growing a bismuth-substituted iron garnet single crystal.

Then, using a known procedure, the 1-inch, and 480 µm thick (111) garnet single crystal [(GdCa)₃(GaMgZr)₅O₁₂] substrates [b2] having a lattice constant of 12.497±0.002 angstroms, was immersed in the melt for 1.0 hour for epitaxial growth while maintaining the melt at 770 degrees Celsius. A crystal obtained was a Ho_{1.1}Tb_{0.6}Bi_{1.3}Fe₅O₁₂ single crystal (referred to as HoTbBiIG single crystal film [B3]) having a Ho_{1.1}Tb_{0.6}Bi_{1.3}Fe₅O₁₂ single crystal film on two opposed sides of the (111) garnet single crystal substrate.

This HoTbBiIG single crystal film [B3] has a thickness of 24 µm on each of the opposed sides and a Faraday rotation Θ_{F} of 45.8 degrees at a wavelength of 786 nm.

Then, the HoTbBiIG single crystal film [B3] was deposited with aluminum by vacuum evaporation to form a reflecting film or mirror on one side thereof and was applied with an antireflection film on the other using a conventional method. Then, a POLARCORE (trade name of CORNING) was securely bonded using an optical bonding agent available on the market onto the HoTbBiIG single crystal film [B3] side. The film was cut into pieces having a predetermined size of 2.5 mm by 2.5 mm with which to make a magnetooptic sensor head.

The magnetooptic sensor head was mounted to the magnetooptic sensor head terminal of the reflection type magnetooptic sensor shown in Fig. 1. The tip end portion of the magnetooptic sensor head was placed in position within a magnetic field applying apparatus (trade name is MAGNET, manufactured by MAGNETICS).

A 786 µm signal light from a light source (trade name is SEMICONDUCTOR LASER, Model LT024MD/PD, manufactured by Sharp) was transmitted through the lens, half mirror, light inputting/outputting path having a core diameter of 400 µm to the magnetooptic sensor head. Then, the light was reflected back along the optical fiber and was again reflected by the half mirror to the photodetector (trade name is Model AQ-111 POWER METER, manufactured by Ando Denki).

Measurement was made for various magnetic fields applied to the magnetooptic sensor head. The Faraday rotator was magnetically saturated in a magnetic field of 1000 Oe. The difference in light intensity between when the Faraday rotator is applied with a magnetic field of 1000 Oe and when not applied, was 3.3dB.

### Example 13

A magnetooptic sensor head was manufactured in the following manner.

A 500 milliliter platinum crucible was placed on an LPE furnace, which platinum crucible contained therein a lead oxide (PbO, 4N) of 843 grams, a bismuth oxide (Bi₂O₃, 4N) of 978 grams, a ferric oxide (Fe₂O₃, 4N) of 120 grams, a gallium oxide (Ga₂O₃, 4N) of 4.5 grams, a boron oxide (B₂O₃, 5N) of 38 grams, a gadolinium oxide (Gd₂O₃, 3N) of 6.5 grams, and yttrium (Y₂O₃, 3N) of 4.0 grams. The content of the crucible was heated to a temperature of 1000 degrees Celsius. The melted content was sufficiently beaten for a homogeneous mixture and was then cooled down to a melt temperature of 773 degrees Celsius to produce a melt for growing a bismuth-substituted iron garnet single crystal.

Then, using a known procedure, a 1-inch, and 480 µm thick (111) garnet single crystal [(GdCa)₃(GaMgZr)₅O₁₂] substrate [b2], was immersed in the melt for 1.2 hour for epitaxial growth while maintaining the melt at 773 degrees Celsius. A crystal obtained was a Y_{0.9}Gd_{0.9}Bi_{1.2}Fe_{4.8}Ga_{0.2}O₁₂ single crystal (referred to as YGdBiGaIG single crystal film [B4]) having a Y_{0.9}Gd_{0.9}Bi_{1.2}Fe_{4.8}Ga_{0.2}O₁₂ single crystal film on each of two opposed sides of the (111) garnet single crystal substrate.

The YGdBiGaIG single crystal B4 has a thickness of 13.5 µm on each of two opposed side, a Faraday rotation Θ_{F} of 42.9 degrees at a wavelength of 783 nm, and saturated magnetization of 600 Oe.

Then, using a conventional method, the YGdBiGaIG single crystal [B4] was deposited with aluminum to form a reflecting film on one side thereof and was applied with an antireflection film on the other using a conventional method. Then, a POLARCORE (trade name, manufactured by CORNING) having an antireflection film applied thereon, was securely bonded by an optical bonding agent to the antireflection film side of the YGdBGaIG single crystal film [B4]. The YGdBiGaIG single crystal [B4] was cut into pieces having a predetermined size of 2.5 mm by 2.5 mm, thereby providing a magnetooptic sensor head.

The thus manufactured magnetooptic sensor head was mounted to the light inputting/outputting path of a magnetooptic sensor, which includes a light branching device (Model 200S-D2, manufactured by Mitsubishi Gasu Kagaku) in the form of a polymer optical guide shown in Fig. 9. The light inputting/outputting path is an optical fiber having a core diameter of 200 µm. The tip end portion of the magnetooptic sensor head was placed in position within a magnetic field applying apparatus (trade name is MAGNET, manufactured by MAGNETICS).

A 0.783 µm laser is transmitted from a light source (stabilized LD light source, Kette System Service) to the magnetooptic sensor head and the light reflected back from the magetooptic sensor head was directed to the photodetector (trade name is Model AQ-111 POWER METER, manufactured by Ando Denki). The intenisty of light was measured for various magnetic fields applied to the magnetooptic sensor head. The Faraday rotator was magnetically saturated in a magnetic field of 600 Oe. The difference in light intensity between when the Faraday rotator is applied with a magnetic field of 600 Oe and when not applied, was 3.6 dB.

### Example 14

The difference in intensity was measured in the same way as in Example 13 except that the magnetooptic sensor head used in Example 12 was used in place of the magnetooptic sensor head used in Example 13. The difference was 3.7 dB in a magnetic field of 600 Oe.

### Example 15

The HoTbBiIG single crystal film on one side of the HoTbBiIG single crystal film [B3] manufactured in Example 12, was removed by polishing method to provide a single-sided HoTbBiIG film [B5] and then an antireflection film was applied on each of opposed surfaces of the HoTbBiIG single crystal film [B3].

Likewise, the YGdBiGaIG single crystal film on one side of the YGdBiGaIG single crystal film [B4] was removed by polishing method to provide a YGdBiGaIG single-sided film [B6]. Then, the YGdBiGaIG single-sided film [B6] was applied with an antireflection film on the YGdBiGaIG single crystal side, and was deposited with aluminum by vacuum evaporation on the (111) garnet single crystal substrate side.

The YGdBiGaIG single-sided film [B6] and the HoTbBiIG single-sided film [B5] were placed together so that the YGdBiGaIG single crystal side and the HoTbBiIG single crystal side are in close contact with each other. Then, a polarizer (trade name is POLARCORE manufactured by CORNING) was securely bonded by an optical bonding agent available on the market onto the substrate surface of the HoTbBiIG single-sided film [B5]. The bonded film was cut into pieces having a predetermined size of 2.5 mm by 2.5 mm, thereby providing a magnetooptic sensor head. Measurement was made in the same way as in Example 13 and the difference in intensity of light was 3.0 dB in a magnetic field of 1000 Oe.

### Example 16

Measurement was made in the same way as in Example 15 except that the 0.85 µm light source (Model HK-5105, LED stabilized light sorce, manufactured by Shimazu Seisakusho) was used instead of the 0.783 µm light source used in Example 15. The difference in intensity was 2.4 dB in a magnetic field 1000 Oe.

### Example 17

A magnetooptic sensor head was manufactured in the following manner.

A 500 milliliter platinum crucible was placed on an LPE furnace, which platinum crucible contained therein a lead oxide (PbO, 4N) of 843 grams, a bismuth oxide (Bi₂O₃, 4N) of 978 grams, a ferric oxide (Fe₂O₃, 4N) of 128 grams, a boron oxide (B₂O₃, 5N) of 38 grams, an europium oxide (Eu₂O₃, 3N) of 4.2 grams, and a holmium oxide (Ho₂O₃, 3N) of 9.0 grams. The content of the crucible was heated to a temperature of 1000 degrees Celsius. The melted content was sufficiently beaten for a homogeneous mixture and was then cooled down to a melt temperature of 766 degrees Celsius to provide a melt for growing a bismuth-substituted iron garnet single crystal.

Then, using a known procedure, a 1-inch, 480 µm thick (111) garnet single crystal [(GdCa)₃(GaMgZr)₅O₁₂] substrates [b2] was immersed in the melt for 1.0 hour for epitaxial growth while maintaining the melt at 766 degrees Celsius. A single crystal obtained was a Ho_{1.1}Eu_{0.6}Bi_{1.3}Fe₅O₁₂ single crystal (referrred to as HoEuBiIG single crystal film [B7] hereafter) having a Ho_{1.1}Eu_{0.6}Bi_{1.3}Fe₅O₁₂ single crystal film on each of two opoosed sides of the (111) garnet single crystal substrate.

The HoEuBiIG single crystal film [B7] has a thickness of 20 µm on each of the opposed sides, a Faraday rotation Θ_{F} of 43.8 degrees at a wavelength of 783 nm, and a magnetic saturation at 1200 Oe. Measurement was made in the same way as in Example 1 with the result that the difference in intensity of light was 4.0 dB in a magnetic field of 1200 Oe.

### Example 18

Using a known procedure, epitaxial growth was carried out for 2.0 hour at a melt temperature of 770 degrees Celsius with a 1-inch, 480 µm thick (111) garnet single crystal [(GdCa)₃(GaMgZr)₅O₁₂] substrates [b2] in contact with the surface of the melt for growing bismuth-substituted iron garnet single crystal used in Example 12. A single crystal obtained was a HoTbBiIG single crystal film [B8].

The HoTbBiIG single crystal film [B8] has a thickness of 46 µm and a Faraday rotation Θ_{F} of 43.9 degrees at a wavelength of 786 nm at saturated magnetization.

By using a conventional method, the HoTbBiIG single crystal film [B8] was cut substantially in half to provide a HoTbBiIG single crystal film [B8-1] and a HoTbBiIG single crystal film [B8-2]. The HoTbBiIG single crystal film [B8-1] was applied with an antireflection film on each of opposed sides thereof. Then, then the HoTbBiIG single crystal film [B8-1] and a polarizer (trade name is POLARCORE manufactured by CORNING) having an antireflection film applied thereon were placed together and securely bonded by an optical bonding agent so that the polarizer was in close contact with the HoTbBiIG single crystal side of the HoTbBiIG single crystal film [B8-1]. The HoTbBiIG single crystal film [B8-2] was applied with an antireflection film on the HoTbBiIG single crystal side thereof and was deposited aluminum on the (111) garnet single crystal substrate side to form a reflecting film thereon.

The thus manufactured polarizer-HoTbBiIG single crystal film [B8-1] block and the HoTbBiIG single crystal film [B8-2]-reflecting film block were bonded together using an adhesive so that the (111) garnet single crystal substrate side of the polarizer-HoTbBiIG single crystal film [B8-1] block was in close contact with the HoTbBiIG single crystal side of the HoTbBiIG single crystal film [B8-2]-reflecting film block. The bonded block was then cut into pieces having a predetermined size of 2.5 mm by 2.5 mm to provide a magnetooptic sensor head. Measurement was made in the same way as in Example 13 and the difference in intensity of light was 3.7 dB in a magnetic field of 1000 Oe.

### Example 19

The HoTbBiIG single crystal [B1] manufactured in Example 1 was deposited with aluminum on one side thereof to form a reflecting film or mirror and was applied with an antireflection film on the other using a conventional method. The HoTbBiIG single crystal [B1] was then cut into pieces having a predetermined size of 2.5 mm by 2.5 mm, thereby providing a HoTbBiIG single crystal [B1]-reflection film block.

Arbitrary five blocks of the thus manufactured HoTbBiIG single crystal [B1]-reflecting film blocks were picked out. Each of the five blocks and the HoTbBiIG single crystal [B1] were placed together and securely bonded using an optical bonding agent available on the market so that the HoTbBiIG single crystal [B1] film side was in close contact with the HoTbBiIG single crystal [B1] manufactured in Example 1. Then, a polarizer (trade name is POLARCORE, manufactured by CORNING) having an antireflection film applied thereon was mounted on the HoTbBiIG single crystal [B1] film and was then securely bonded by an epoxy adhesive to provide a polarizer-Faraday rotator [B1-B1]-reflecting film block.

Then, a 400 µm core diameter polymer-clad optical fiber, which serves as a light inputting/outputting path, was mounted to the magnetooptic sensor head.

The performance of the Faraday rotator was examined in a similar way to Example 1. The Faraday rotator [B1-B1] was magnetically saturated in a magnetic field of 1000 Oe. The difference in light intensity between when the Faraday rotator was applied with a magnetic field of 1000 Oe and when no magnetic field was applied, was in the range of 1.7-2.1 dB and 1.8 dB on average.

### Example 20

A magnetooptic sensor head was manufactured in the same way as in Example 1 except that an ingot was cut into substrates so that the [111] axis of the substrate makes an angle of 1 degrees with an axis normal to the surface of the substrate. This substrate is referred to as substrate [a8] in the present invention. Measurement was made in the same way as in Example 1.

The Faraday rotator [A9-B1] was saturated in a magnetic field of 1000 Oe. The difference in light intensity between when the Faraday rotator was applied with a magnetic field of 1000 Oe and when no magnetic field was applied, was in the rage of 1.8-2.1 dB and 2.0 dB on average.

### Example 21

A magnetoooptic sensor head was manufactured in the same way as in Example 8 except that the the HoTbBiIG single crystal [A9]-reflecting film block manufactured in Example 20 was used in place of the HoTbBiIG single crystal [A1]-reflecting film block. Then, the performance of the Faraday rotator [A9-B2] was evaluated in the same manner as in Example 1.

The Faraday rotator [A9-B2] was saturated in a magnetic field of 1000 Oe. The difference in light intensity between when the Faraday rotator was applied with a magnetic field of 1000 Oe and when no magnetic field was applied, was in the range of 1.8-2.1 dB and 2.0 dB on average.

### Example 22

An antireflection film was applied on both sides of the HoTbBiIG single-sided film [B8-1], and then the HoTbBiIG single-sided film [B8-1] and a POLARCORE having an antireflection film applied thereon were placed together and securely bonded using an optical bonding agentso that the POLARCORE was in close contact with the (111) garnet single crystal substrate side. The HoTbBiIG manufactured in Example 18 was applied with an antireflection film on the HoTbBiIG single crystal side thereof and was deposited with aluminum by vacuum evaporation on the (111) garnet substrate side.

Then, thus manufactured polarizer-HoTbBiIG single crystal film [B8-1] block and the HoTbBiIG single crystal film [B8-2]-reflecting film block were placed together and securely bonded together so that the HoTbBiIG single crystal side of the thus manufactured polarizer-HoTbBiIG single crystal film [B8-1] block was in close contact with the HoTbBiIG single crystal side of the HoTbBiIG single crystal film [B8-2]-reflecting film block. This bonded block was cut into pieces having a predetermined size of 2.5 mm by 2.5 mm, thereby providing a magnetooptic sensor head. Measurement was made in the same way as in Example 13 and the difference in light intensity was 0.7 dB in a magnetic field of 1000 Oe.

### Example 23

A magnetooptic sensor head was manufactured in the same way as in Example 1 except that an ingot was cut into substrates so that the [111] axis of the substrate makes an angle of 65 degrees with an axis normal to the surface of the substrate. This substrate is referred to as substrate [a9] and is used for growing single crystal thereon. Measurement was made in the same way as in Example 1.

The Faraday rotator [A10-B1] was saturated in a magnetic field of 1000 Oe. The difference in light intensity between when the Faraday rotator was applied with a magnetic field of 1000 Oe and when no magnetic field was applied, was in the range of 3.2-3.5 dB and 3.3 dB on average.

## Claims

1. A reflection type magnetooptic sensor head having a light inputting/outputting path, a polarizer, a Faraday rotator, and a reflecting film aligned in order, wherein said reflecting film is substantially perpendicular to an optical axis of a light exiting said Faraday rotator; and said Faraday rotator is constructed of a plurality of (111) bismuth-substituted iron garnet single crystal films.

2. The reflection type magnetooptic sensor head according to Claim 1, wherein said polarizer, Faraday rotator, and reflecting film are closely placed together in a unitary construction with or without a (111) garnet single crystal substrate therebetween.

3. The reflection type magnetooptic sensor head according to Claim 1 or Claim 2, wherein said (111) bismuth-substituted iron garnet single crystal films are two-layer bismuth-substituted iron garnet single crystal films.

4. The reflection type magnetooptic sensor head according to Claim 1, Claim 2, or Claim 3, wherein said (111) bismuth-substituted iron garnet single crystal films are selected from bismuth-substituted iron garnet crystal films having a [111] axis at an angle in the range of 1-60 degrees with an axis normal to the film surface and/or bismuth-substituted iron garnet crystal films having a [111] axis substantially in line with an axis normal to the film surface.

5. The reflection type magnetooptic sensor head according to Claim 1, Claim 2, or Claim 3, wherein said (111) bismuth-substituted iron garnet single crystal films include a first and second (111) bismuth-substituted iron garnet single crystal films, said first (111) bismuth-substituted iron garnet single crystal film having a [111] axis at an angle in the range of 1-60 degrees with an axis normal to the film surface, and said second (111) bismuth-substituted iron garnet single crystal film having a [111] axis substantially in line with an axis normal to the film surface.

6. The reflection type magnetooptic sensor head according to Claim 1, Claim 2, or Claim 3, wherein said plurality of bismuth-substituted iron garnet single crystal films include bismuth-substituted iron garnet single crystal films having a [111] axis at an angle in the range of 3-45 degrees with an axis normal to the film surface and a (111) bismuth-substituted iron garnet crystal films having a [111] axis substantially in line with an axis normal to the film surface.

7. The reflection type magnetooptic sensor head according to Claim 4, wherein said (111) bismuth-substituted iron garnet single crystal films having a [111] axis at an angle in the range of 1-60 degrees with an axis normal to the film surface is of a three-layer construction where a (111) bismuth-substituted iron garnet single crystal film is formed on each of opposed sides of a (111) bismuth-substituted iron garnet single crystal substrate, and/or said (111) bismuth-substituted iron garnet single crystal films having a [111] axis substantially in line with an axis normal to the film surface is of a three-layer construction where a (111) bismuth-substituted iron garnet single crystal film is formed on each of opposed sides of a (111) bismuth-substituted iron garnet single crystal substrate.

8. The reflection type magnetooptic sensor head according to Claims 1, 2, 3 wherein said plurality of bismuth-substituted iron garnet single crystal films include two or more types, each of said types having a different chemical composition from other types.
